# EUROPEAN PATENT APPLICATION

(11) **EP 1 619 802 A1**
(43) Date of publication of application: **25.01.2006**
(21) Application number: 05252188.7
(22) Date of filing: 07.04.2005
(51) Int. Cl.: H03M 13/29

(54) **Communications device and wireless communications system**

(30) Priority: 21.07.2004 JP 2004213093
(71) Applicant: FUJITSU LIMITED, Kawasaki-shi, Kanagawa 211-8588 (JP)
(72) Inventor: Obuchi, Kazuhisa, c/o Fujitsu Limited, Kawasaki-shi, Kanagawa 211-8588 (JP); Miyazaki, Shunji, c/o Fujitsu Limited, Kawasaki-shi, Kanagawa 211-8588 (JP); Yano, Tetsuya, c/o Fujitsu Limited, Kawasaki-shi, Kanagawa 211-8588 (JP)
(74) Representative: Fenlon, Christine Lesley

(57) **Abstract**

A turbo coding device and turbo decoding device that allow for the presence of interleaving in the error correction coding process improves error correction capability even when the decoding device does not employ a scheme whereby extrinsic information is circulated as in a turbo decoding device. A turbo decoding device for decoding data that is obtained by performing error detection coding on a plurality of data blocks and further subjecting that data to turbo coding that includes interleaving in the coding process, comprises a rearrangement unit (18) operable to perform interleaving between a first decoding (16) a second decoding (21), an error detection unit (25) operable to perform error detection processing for each block based on data after the first decoding, and an adjustment unit (26) operable to adjust a likelihood indicated by data obtained after decoding in the first decoder but prior to the interleaving and corresponding to blocks evaluated as having no errors by the error detection unit, so as to increase reliability of the data.

## Description

This application is related to and claims priority to Japanese Application No. 2004-213093 filed July 21, 2004 in the Japanese Patent Office, the contents of which are incorporated by reference herein.

The present invention relates to coding devices and decoding devices, and in particular to devices in which the codes include turbo codes wherein interleaving is performed in the coding process.

The art of transmitting information coded with a combination of error detection code and turbo code has been previously considered.

Namely, coded data, obtained by performing error detection coding on the data blocks to be transmitted, multiplexing them, and then turbo coding, is transmitted.

The decoding device receives this, performs turbo decoding, and then executes error detection processing on each data block to confirm whether the received data has or does not have errors.

An example of a known coding device of this sort will be described below.

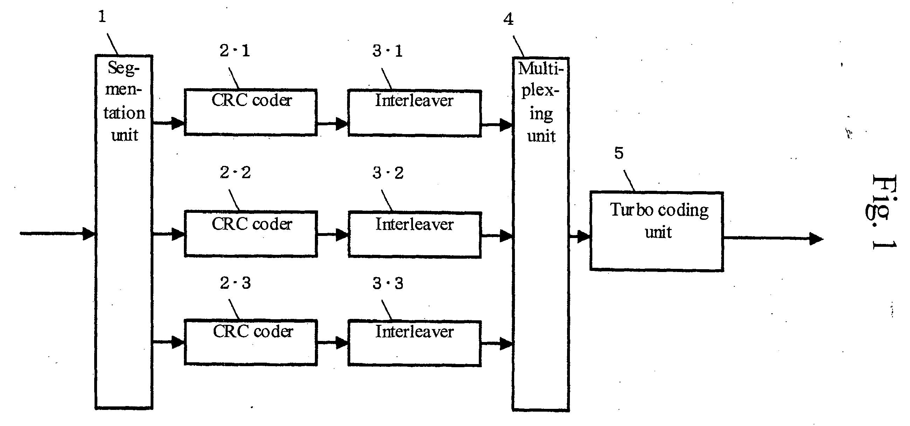

Figure 1 is a drawing illustrating the coding process involved. In the drawing, 1 is a segmentation unit, 2-1 through 2-3 are CRC coders, 3-1 through 3-3 are interleavers, 4 is a multiplexing unit, and 5 is a turbo coding unit.

Information from the information source that is to be coded is first segmented into n segments by the segmentation unit 1, which are mapped to n CRC coders 2-1 through 2-n. In the CRC coders 2-1 through 2-n, CRC evaluation information is added to each distributed piece of information, which is output as an error detection code.

In the interleavers 3-1 through 3-n, interleaving of the sequence of error detection codes output by each CRC coder is performed. The n interleaved error detection codes obtained from the interleavers 3-1 through 3-n are multiplexed by the multiplexing unit 4.

Error correction coding is performed on this multiplexed code by the turbo coder 8, and the resulting error correction code is transmitted to the decoding device.

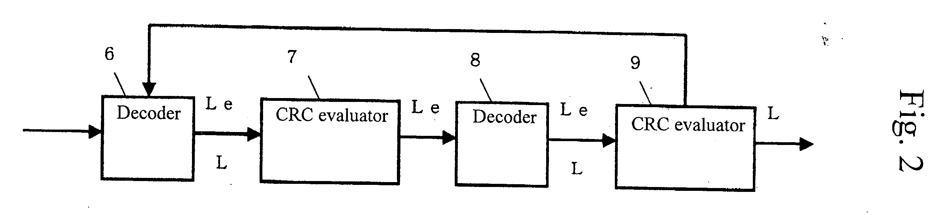

Figure 2 is a drawing illustrating a turbo decoding device that decodes the error correction codes coded by means of the coding process illustrated in Figure 1.

In the drawing, 6 and 8 are two decoders that perform iterative decoding, and 7 and 9 are CRC evaluators.

When received information is input into the decoder 6, iterative decoding is performed while exchanging extrinsic information Le between this decoder 6 and the other decoder 8. In this iterative decoding process, the CRC evaluator 7 (9) following each decoder 6 (8) successively performs CRC evaluation on every piece of likelihood information L output by the decoder 6 (8).

When the result of the CRC evaluation is that there was a frame without errors, the CRC evaluator 6 (8) increases the value of the extrinsic information Le corresponding to that frame and inputs it into the following decoder 6 (8).

The aforementioned coding and decoder are described in detail in Unexamined Japanese Patent Application Publication 2000-201085

The background art presented above is an art that is applicable in cases where error detection code and error correction code are used in combination, but it does not allow for the presence of interleaving in the error correction coding process.

Therefore, a need arises for a turbo coding device and turbo decoding device that allow for the presence of interleaving in the error correction coding process, with improved error correction capability even when the decoding device does not employ a scheme whereby extrinsic information is circulated as in a turbo decoding device.

The background art presented above is an art that is applicable in cases where error detection code and error correction code are used in combination, but it does not allow for the presence of interleaving in the error correction coding process.

Therefore, it is desirable to provide a turbo coding device and turbo decoding device that allow for the presence of interleaving in the error correction coding process.

It is also desirable to provide a decoding device with improved error correction capability even when the decoding device does not employ a scheme whereby extrinsic information is circulated like in a turbo decoding device.

Embodiments of the present invention can also achieve the effects that are derived from the various arrangements indicated in the best mode for practicing the present invention, described below, and that could not be obtained by the prior art.

In one embodiment of an aspect of the present invention, a turbo decoding device for decoding data that is obtained by performing error detection coding on a plurality of data blocks and further subjecting that data to turbo coding that includes interleaving in the coding process, comprises a rearrangement unit operable to perform interleaving between a first decoding a second decoding, an error detection unit operable to perform error detection processing for each block based on data after the first decoding, and an adjustment unit operable to adjust a likelihood indicated by data obtained after decoding in the first decoder but prior to the interleaving and corresponding to blocks evaluated as having no errors by the error detection unit, so as to increase reliability of the data.

In one embodiment of the present invention, the adjustment unit is further operable to adjust the likelihoods by increasing the likelihoods for data blocks for which no error was detected, wherein the likelihood after being increased is a value greater than a value that can be taken on by the likelihood of data to be decoded that is input into the decoding device.

In one embodiment of another aspect of the present invention, a turbo decoding device for decoding data that is obtained by performing error detection coding on a plurality of data blocks and further subjecting that data to turbo coding that includes interleaving in the coding process, comprises a rearrangement unit operable to perform deinterleaving between a first decoding a second decoding, an error detection unit operable to perform error detection processing for each the block based on data after the second decoding, and an adjustment unit operable to adjust likelihoods indicated by data obtained after decoding in the second decoder and after the deinterleaving and corresponding to blocks evaluated as having no errors by the error detection unit, so as to increase the reliability of the data.

In one embodiment of the present invention, the adjustment unit is further operable to adjust the likelihoods by increasing the likelihoods for data blocks for which no error was detected, wherein the likelihood after being increased is a value greater than a value that can be taken on by the likelihood of data to be decoded that is input into the decoding device.

In one embodiment of another aspect of the present invention, a turbo decoding device for decoding data that is obtained by performing error detection coding on a plurality of data blocks and further subjecting that data to turbo coding that includes interleaving in the coding process, comprises an error detection unit operable to perform error detection processing on each data block in a non-interleaved region of the data and an adjustment unit operable to adjust likelihoods corresponding to data blocks for which no error was detected by the error detection unit, in the non-interleaved region of the data, so as to increase the reliability of the data.

In one embodiment of the present invention, the adjustment unit is further operable to adjust the likelihoods by increasing the likelihoods for data blocks for which no error was detected, wherein the likelihood after being increased is a value greater than a value that can be taken on by the likelihood of data to be decoded that is input into the decoding device.

In one embodiment of another aspect of the present invention, a coding device comprises a rearrangement unit operable to rearrange data obtained by performing error detection coding on a plurality of data blocks so as to mix that data between blocks and a turbo coding unit operable to perform error correction coding on the rearranged data.

In one embodiment of another aspect of the present invention, a turbo decoding device for performing decoding on data obtained by rearranging data obtained by performing error detection coding on a plurality of data blocks so as to mix that data between blocks in a rearrangement unit, and further subjecting the rearranged data to turbo coding that includes interleaving in the coding process, comprises an error detection unit operable to perform error detection on each data block in a non-interleaved region and an adjustment unit operable to adjust likelihoods corresponding to data blocks for which no error was detected by the error detection unit, in a non-interleaved region, so as to increase reliability of the data.

In one embodiment of the present invention, the adjustment unit is further operable to adjust the likelihoods by increasing the likelihoods for data blocks for which no error was detected, wherein the likelihood after being increased is a value greater than a value that can be taken on by the likelihood of data to be decoded that is input into the decoding device.

In one embodiment of another aspect of the present invention, a turbo decoding device for performing decoding on data that is obtained by performing error detection coding on a plurality of data blocks and further subjecting that data to turbo coding that includes interleaving in the coding process, comprises a memory operable to perform interleaving or deinterleaving in the decoding process and a rewriting unit operable to rewrite likelihoods stored in the memory for data blocks that were evaluated as having no errors in the decoding process through error detection processing.

In one embodiment of the present invention, the rewriting unit is further operable to perform the rewriting based on management information in a management unit that manages addresses of the likelihoods to be rewritten for each block.

In one embodiment of the present invention, the rewriting unit is further operable to rewrite likelihoods stored in the memory by increasing the likelihoods for data blocks for which no error was detected, wherein the likelihood after being increased is a value greater than a value that can be taken on by the likelihood of data to be decoded that is input into the decoding device.

In one embodiment of another aspect of the present invention, a decoding device for performing error correction decoding on data that is obtained by performing error detection coding on a plurality of data blocks and further subjecting that data to error correction coding, comprises an error detection unit operable to perform error detection on the data to be decoded prior to the decoding, an adjustment unit operable to perform adjustment so as to increase reliability of likelihoods for the data blocks for which no error was detected by the error detection unit, and a decoding unit operable to perform error correction decoding using the likelihoods after the adjustment.

In one embodiment of the present invention, the error detection unit is further operable to perform error detection on the result of the decoding and the adjustment unit is further operable to perform adjustment so as to increase reliability of likelihoods for the data blocks for which no error was detected in the additional error detection processing by the error detection unit.

In one embodiment of the present invention, the adjustment unit is further operable to perform adjustment by increasing the likelihoods for data blocks for which no error was detected, wherein the likelihood after being increased by the adjustment is a value greater than a value that can be taken on by the likelihood of data to be decoded that is input into the decoding device.

In one embodiment of another aspect of the present invention, a decoding device for performing error correction decoding on data that is obtained by performing error detection coding on a plurality of data blocks and further subjecting that data to error correction coding, comprises a decoding unit operable to perform decoding on data to be decoded, an error detection unit operable to perform error detection for each data block based on results of the decoding, and an adjustment unit operable to adjust likelihoods for those data blocks to be decoded that had no error according to the error detection so as to increase reliability of the data, wherein the data to be decoded is again input into the decoding unit to execute decoding after the adjustment.

In one embodiment of the present invention, the adjustment unit is further operable to adjust the likelihoods by increasing the likelihoods for data blocks for which no error was detected in an iterative decoding process, wherein the likelihood after being increased by the adjustment is a value greater than a value that can be taken on by the likelihood of data to be decoded that is input into the decoding device.

In one embodiment of another aspect of the present invention, a turbo decoding device for performing decoding on data that is obtained by performing error detection coding on a plurality of data blocks and further subjecting that data to turbo coding that includes interleaving in the coding process, comprises an adjustment unit operable to increase likelihoods for data blocks for which no error was detected in an iterative decoding process, wherein the likelihood after being increased by the adjustment is a value greater than a value that can be taken on by the likelihood of data to be decoded that is input into the decoding device.

Modes of embodiment of the present invention are described below by way of example with reference to the drawings, in which:
Figure 1 is a diagram illustrating a previously considered coding process;
Figure 2 is a diagram illustrating a previously considered turbo decoding device;
Figure 3 is a diagram illustrating a turbo coding device according to an embodiment of the present invention;
Figure 4 is a diagram illustrating the turbo coding device according to an embodiment of the present invention.
Figure 5 is a diagram illustrating the coding device according to an embodiment of the present invention.
Figure 6 is a diagram illustrating an example of the error detection unit according to an embodiment of the present invention.
Figure 7 is a diagram illustrating an example of the decoding device according to an embodiment of the present invention; and
Figure 8 is a diagram illustrating an example of the decoding device according to an embodiment of the present invention.

### Description of First Embodiment

The first embodiment allows for the inclusion of interleaving in the error correction coding process.

In the drawing, 10 and 12 are coding units (error correction coding units) that perform for instance convolutional coding. 11 is an interleaver that performs processing to rearrange the order of the input data.

It may be assumed as a precondition that the information U to be coded contains at least two information blocks, and that each information block has been subjected to error detection coding. Here, three information blocks, A, B, and C will be assumed, and it will be assumed that CRC check bits, constituting the result of CRC computation for the respective block, have been attached to each block.

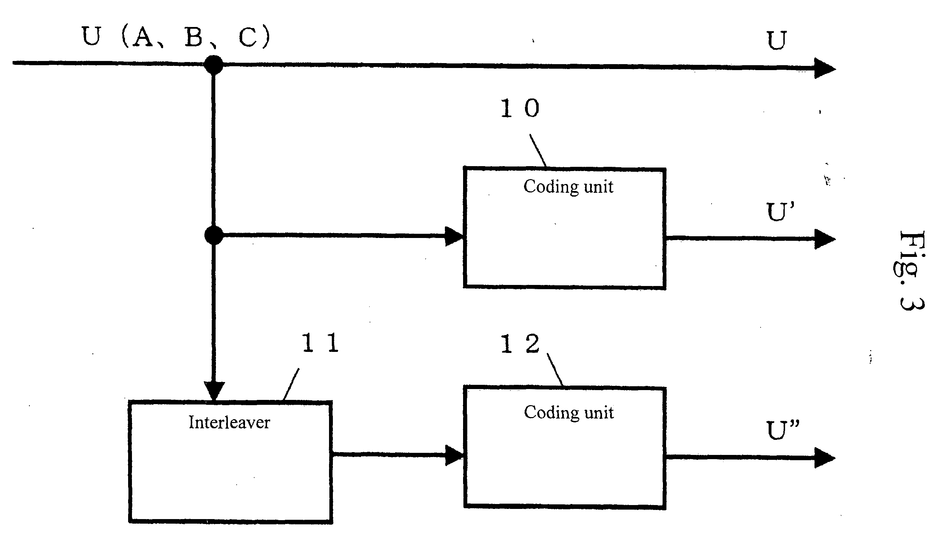

When information U, containing a plurality of blocks that have been subjected to error detection coding in this manner, is input into the turbo coding device shown in Figure 3, U, U', and U" are output as a result.

Here, U is the input data to be coded; U' is the data obtained by performing coding, such as convolutional coding, on U; and U" is the data obtained by interleaving U in interleaver 11 and further subjecting the resulting data to coding, such as convolutional coding, in the coding unit 12. U' and U" are so-called redundancy data, also known as parity bits.

The information (U, U', U") coded in this manner is rate-matched if necessary, and is transmitted or is written to a storage medium or the like.

Next, the turbo decoding device that performs decoding on the data coded by such a turbo coding device will be described.

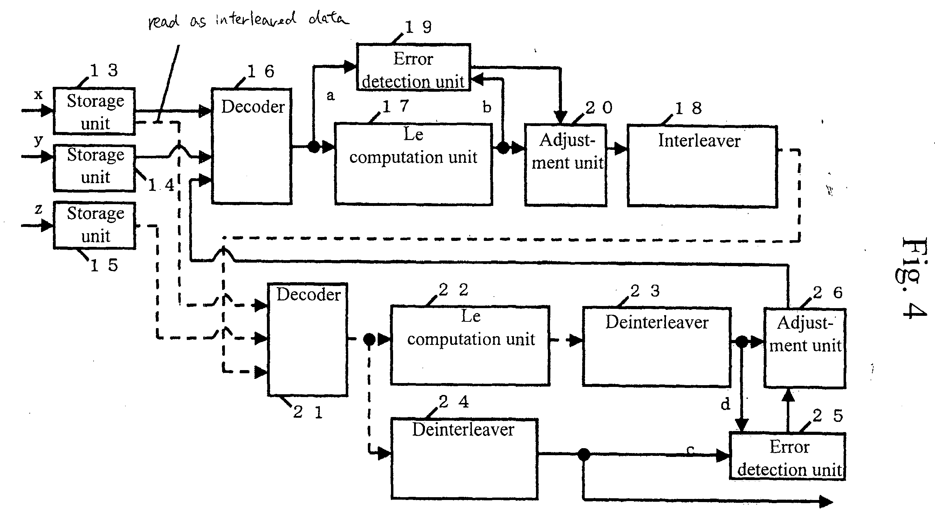

Figure 4 illustrates a turbo decoding device according to an embodiment of the present invention.

In the drawing, 13 through 15 are storage units that store x, y and x, which are the information obtained by receiving U, U', and U" or reading U, U', and U" from a storage medium. Of course, x, y, and z may also be stored in separate storage regions is a single common memory.

16 and 21 are so-called component decoders that perform error correction decoding by means of a decoding algorithm such as SOVA (Soft Output Viterbi Algorithm) or MAP (Maximum A Posteriori Probability).

17 and 22 are Le computation units that compute and output the extrinsic information likelihood Le based on the a posteriori likelihood L output from the decoders 16 and 21.

18 represents an interleaver that performs the processing of rearranging data by varying the write order and read order. 23 and 24 represent deinterleavers that also perform the processing of rearranging data by varying the write order and read order. In this case, however, the processing performed is the reverse of that of the interleaver 18. Namely, when interleaver 18 and deinterleaver 23 (24) are connected and data is input, it would be rearranged by the interleaver 18, and would be returned to the original order by the deinterleaver 23 (24).

19 and 25 are error detection units that perform error detection on each error detection coded information block (A, B, C). For example, error detection based on CRC calculation using CRC check bits can be applied here.

20 and 26 represent adjustment units that adjust the likelihood related to blocks evaluated as having no error based on the results of the error detection in the error detection units 19 and 25. Correction does not have to be performed on blocks that had an error.

In the drawing, the handling of data that has and has not been rearranged by interleaving is represented by dashed and solid lines for ease of understanding.

Next, the operation of this turbo decoding device will be described.

As shown in Figure 3, the turbo coded data U, U', and U" are input into the turbo decoding device in the form of data x, y, and z, which may contain errors due to the effects of the transmission path, errors in reading and writing using a storage medium, etc. x, y, and z are the data to be decoded by this turbo decoding device, and each contains hard decision data as well as soft decision data in the form of likelihood information.

The soft decision data is information indicating how likely the hard decision data is. For example, in case where the turbo coded data is transmitted by assigning to signal points on a phase plane, the decision as to what signal point it corresponds to is hard decision data, while how close is it to that signal point is soft decision data.

The x, y, and z input into the turbo decoding device are stored respectively in storage units 13, 14 and 15 in order to use them in an iterative decoding process using decoders 16 and 21.

For the first decoding, x and y are input into decoder 16, where decoding is performed using the previously described algorithm, and the a posteriori likelihood L is output as the decoding result. For the decoding after the first cycle, in addition to x and y, the extrinsic information likelihood Le after deinterleaving in the deinterleaver 23 is used as an a priori likelihood in performing the decoding.

The a posteriori likelihood L is furthermore converted to extrinsic information likelihood Le in the Le computation unit 17 in order to use it for the next decoding (decoding performed as an iterative decoding step).

The extrinsic information likelihood Le can be found by subtracting the x contained in the a posteriori likelihood L (in the decoding after one cycle, by subtracting x in addition to the extrinsic information likelihood Le from the adjustment unit 26). This subtraction allows one to obtain the new likelihood information given by the decoding.

The extrinsic information likelihood Le is input into the interleaver 18 via the adjustment unit 20.

The interleaver 18 performs the same rearrangement as the interleaver 11 on the input extrinsic information likelihood Le, and provides the post-interleaving extrinsic information likelihood Le as the a priori likelihood to the decoder 21.

16 through 20, 25, and 26 can be thought of as components that handle non-rearranged data (pre-interleaving data), and 21 through 24 as components that handle rearranged data (post-interleaving data).

x and z from the storage units 13 and 15 are also input into the decoder 21 along with the extrinsic information likelihood Le.

As described above, the decoder 21 handles rearranged data. Therefore, x is read from the storage unit 13 by interleaving reading and is provided to the decoder 21 as interleaved data. The interleaving here is the same as the interleaving in the interleaver 18.

Meanwhile, z, since it is has already been interleaved by interleaver 11, is read out from the storage unit 15 in the order it was stored in and provided as such to the decoder 21.

In this way, x, z and the extrinsic information likelihood Le from the interleaver 18 are input as a priori likelihoods into the decoder 21, decoding is performed according to the algorithm described above, and the a posteriori likelihood L is output.

Then, in the Le computation unit 22, just as in the Le computation unit 17, x and the a priori likelihood input into the decoder 21 are subtracted from the a posteriori likelihood L to compute a new extrinsic information likelihood Le, which is provided to the deinterleaver 23.

The deinterleaver 23 deinterleaves the input extrinsic information likelihood Le and outputs the result.

The deinterleaved extrinsic information likelihood Le is input via the adjustment unit 26 into the decoder 16, and the second decoding cycle is initiated in the decoder 16.

Once a set number of iterations has been completed (once the decoding of the Nth decoder has been completed), the decoding result of decoder 21 is subjected to the same rearrangement by deinterleaver 24 as in deinterleaver 23, and is output as the decoding result of the turbo decoding device.

With regard to the order of the iterative decoding, while an example was presented where decoding using x and y was performed first, it is also possible to perform the decoding using x and z first.

Furthermore, by time-sharing a decoder, it is also possible to use a single decoder, or to share the interleaver and deinterleaver by executing interleaving and deinterleaving by switching the write pattern and read pattern on a single memory.

The foregoing was an overview of the decoding operation of the turbo decoding device. Below, the operation of the error detection units 19 and 25 and of the adjustment units 20 and 26 will be described in greater detail.

### Error detection and adjustment

The present embodiment has been devised so as not to perform error detection or adjustment of likelihood on rearranged data (post-interleaving data or pre-deinterleaving data).

Namely, the error detection unit 19 performs error detection on data before it is interleaved by the interleaver 18, and the adjustment unit 20 performs adjustment on data before it is subjected to interleaving by the interleaver 18. Here, this is referred to in particular as performing error detection and adjustment in a non-interleaved region.

Furthermore, the error detection unit 25 performs error detection on data after it has been deinterleaved in deinterleaver 23 (24), and adjustment unit 26 performs adjustment on data after it has been deinterleaved in deinterleaver 23.

For example, the error detection unit 19 acquires the a posteriori likelihood L from the decoder or the extrinsic information likelihood Le from the Le computation unit 17 at point a or b, and performs a CRC check on the parts corresponding to blocks A, B, and C.

Here, if blocks A, B, and C contained in the information (U) input into the turbo coding device are multiplexed block by block in that sequence, then the error detection unit 19 can simply extract the data corresponding to each block by separating into specific lengths and perform CRC check computations. Preferably, a window pulse for extraction of blocks A, B, and C is generated, and the data of each interval is captured to perform the CRC computation.

If a block is discovered that has been confirmed by CRC check computation as having no CRC error, then the likelihood corresponding to that block is adjusted such that its reliability increases.

If blocks A, B, and C contained in the information (U) input into the turbo coding device are multiplexed block by block in that sequence and only block A is judged to have no CRC error, then, of the extrinsic information likelihoods, the data of the time period corresponding to block A can be successively batch-adjusted. Here as well, preferably, window pulses for extraction of blocks A, B, and C are used in the same manner as for CRC computation, and the likelihood for the data of the respective period is adjusted (e.g., by addition or multiplication with a specific value) to a specific value.

Of course, if blocks A and B only are judged to have no CRC error, then, of the extrinsic information likelihoods, the data of the periods corresponding to blocks A and B can be successively batch-adjusted. Of course, if blocks A and B only are judged to have no CRC error, then, of the extrinsic information likelihoods, the data of the periods corresponding to blocks A and B can be each successively batch-adjusted.

As an example of the adjustment, it is desirable to set the likelihood to the maximum value determined by the bit length.

Adjusting as described above makes it possible to avoid complicating the specification of the target data with respect to the error detection and adjustment of data interleaved by interleaver 18 and the error detection and adjustment of data before its is deinterleaved by deinterleaver 23.

Furthermore, since the division of blocks subjected to CRC checking in the error detection unit 19 and division of blocks subjected to adjustment can be carried out using a common division means, it becomes possible to efficiently perform adjustment of likelihoods even in cases where interleaving is carried out in the turbo coding process.

If adjustment of likelihoods is implemented in this manner, the reliability of the likelihood for data confirmed by error detection to have no error will increase, the possibility of bits being updated in the subsequent decoding will decrease, and situations where a data block that was at one point CRC error-free would change to CRC errored are reduced.

For the error detection unit 25 and adjustment unit 26, data is acquired from C or D, and, just like in the case of error detection unit 19, the division of blocks subjected to CRC checking and the division of blocks subjected to adjustment can be performed using a common division means, and the same type of processing can be performed.

Furthermore, since the same division method can be used for the division of blocks performed by the error detection units 19 and 25, the error detection units 19 and 25 may be made into a common error detection unit, and the adjustment in the adjustment units 20 and 26 may be carried out according to the error detection results in this common error detection unit.

Moreover, for blocks that have been evaluated as CRC error-free in the error detection unit 19 or 25, that fact can be stored, and adjustment of likelihood can be executed each time in the iterative decoding process. In this case, it is desirable to not perform CRC computation for blocks that have already been evaluated once as CRC error-free. This allows the computational load to be reduced.

The reason for executing adjustment of likelihoods in this manner without limiting it to just once for each block is that, even if an adjustment to the maximum value has been made, subsequent iterations of decoding may lower the likelihood, and in cases where there are many iterations or the like, repeating the adjustment reduces the possibility of a situation where hard decision data ends up being updated.

Furthermore, while in the above embodiment, the relationship between the number of bits (P) of the likelihood of data input from the storage units 13 through 15 into the decoder 16 (21) in Figure 4 and the number of bits (Q) of the extrinsic information likelihood (a priori likelihood) was not described, it is preferable to make Q greater than P.

This is because, when adjustment that brings the likelihood to the maximum value is carried out in the adjustment units 20 and 26, if P becomes equal to Q, there is the possibility that updating of data will be executed on the data blocks that were judged to be CRC error-free in the decoding process in the decoders 16 and 21. Thus, preferably, by making P 6 bits and Q between 7 and 11 bits, for example, one can prevent the extrinsic information likelihood from becoming to great a value, while also effectively preventing error correction on error-free data blocks.

Setting the relationship of bit numbers in this manner (P<Q) is something that can be similarly applied to the background art illustrated in Figure 2.

### Description of Second Embodiment

For the second embodiment, coding and decoding procedures will be described that offer improvement of additional characteristics in the turbo decoding device in cases where error detection coding is employed in combination with turbo coding.

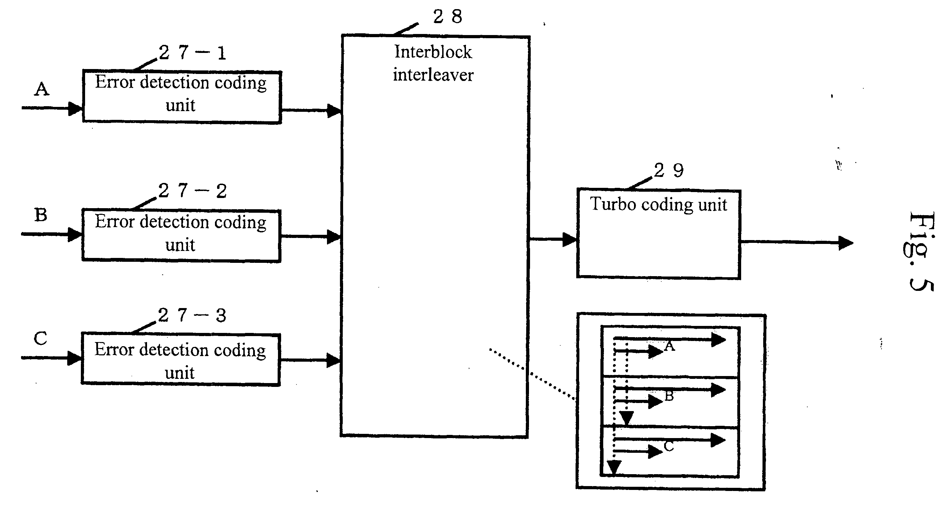

Figure 5 illustrates a coding device according to an embodiment of the present invention.

In the drawing, 27-1 through 27-3 represent error detection coding units that carry out, for instance, CRC coding. 28 represents an interblock interleaver that does not simply multiplex and output the input blocks A, B, and C in that order, but rearranges and outputs them such that the bits belonging to block A, the bits belonging to block B and the bits belonging to block C are mixed among themselves. 29 represents a turbo coding unit; here, it will be assumed that the turbo coding device illustrated in Figure 3 is used.

Next, the operation of the coding device will be described.

The information blocks to be transmitted, A, B, and C (it suffices to have at least two blocks) are input respectively into error detection coding units 27-1 through 27-3, and are output for instance with CRC check bits, which are the result of CRC computation, attached thereto. The data of each block that has been subjected to error detection coding is then input into the interblock interleaver 28.

The interblock interleaver 28 for instance selects and outputs the leading bits of each block in sequence-the first bit of block A, the first bit of block B, the first bit of block C, the second bit of block A, and so on―thereby causing the bits of the individual blocks to be mixed together. Furthermore, as shown in Figure 5, it is possible to mix the bits by writing the data of blocks A, B, and C sequentially starting from the top row in the direction of the solid line, and reading it in sequence starting from the left column. Furthermore, it is preferable to additionally mix the bits between blocks by reordering the rows before reading, as illustrated by the dotted line.

These are merely illustrations: other techniques can be used as well.

The data of the all the blocks mixed up in this manner by the interblock interleaver 28 is coded by the turbo coding unit 29, and a code sequence (U, U', U") is output. It is assumed that the interleaver within the turbo coding unit 29 (corresponding to interleaver 11 of Figure 3) does not perform processing to completely reverse the processing of the interblock interleaver 28 to the original state.

The foregoing was a description of the operation of the coding device according to an embodiment of the present invention. The advantages obtained by using this coding device will be described while referring to Figure 4.

A coding process such as convolutional coding is performed in the turbo coding process, and when decoding the result, it is desirable that the correct bits and error bits be dispersed among each other. This is because if correct bits and error bits were each respectively present in bursts, it would not be possible to efficiently perform error correction.

Based on the arrangement of Figure 4, for blocks that are detected to be error-free by the error detection unit 25, the likelihood is adjusted by the adjustment unit 26 so as to increase reliability. Here, if blocks A, B, and C are simply multiplexed in the order A, B, C, in contrast to what is done by the block interleaver 28 of Figure 5, then the blocks for which the likelihood is adjusted by the adjustment unit 26 will also be bursty, making it impossible to efficiently perform error correction (decoding) in the decoder 16.

However, in this embodiment, which employs an interblock interleaver 28, the blocks for which the likelihood is adjusted by the adjustment unit 26 are mixed together with other blocks, and are at least somewhat dispersed relative to a burst state, making it possible to efficiently perform error correction (decoding) in the decoder 16.

In this way, the second embodiment allows error correction to be performed efficiently, but it requires that the error detection units 19 and 25 be made compatible with interblock interleaving.

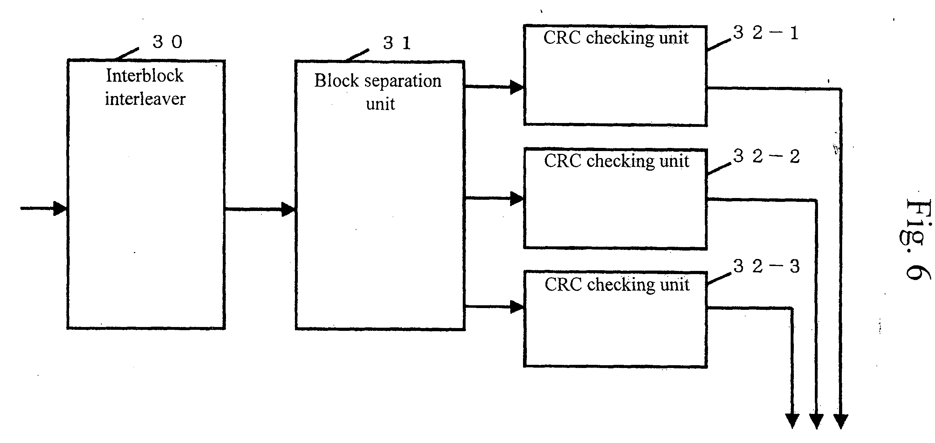

Figure 6 illustrates a configuration of error detection units 19 and 25 that is compatible with interblock interleaving.

In the drawing, 30 is an interblock interleaver, 31 is a block separation unit, and 32-1 through 32-3 are CRC checking units.

The data subject to error detection is rearranged again to return the blocks, mixed by the processing in the interblock interleaver 28 of Figure 5, to their original state.

The data collected into blocks by the interblock interleaver 28 is input into the block separation unit 31, and is output to the CRC checking units 32-1 through 32-3 as data corresponding to blocks A, B, and C respectively.

The CRC checking units 32-1 through 32-3 perform error detection using CRC check bits, and notify the adjustment units to adjust the likelihood for blocks for which no error was detected.

The adjustment units 20 and 26 adjust the likelihood corresponding to the indicated block.

For the likelihood subject to adjustment, one can defme (store) specific bit locations for each block according to the processing performed in the interblock interleaver 28, and adjust the likelihood of those bit locations.

As described above, this embodiment requires a rearrangement process, but it allows the error correction capability to be effectively increased.

### Description of Third Embodiment

In the third embodiment, adjustment is implemented with an interleaver and deinterleaver.

In Figure 4, when the interleaver 18 and deinterleaver 23 are implemented with a memory, the Le output from the Le computation units 17 and 22 would be held temporarily in this memory and likelihood rewriting would be performed on memory regions of the likelihoods corresponding to blocks for which no error was detected by the error detection units 19 and 25.

For example, one could manage (store), for each block, the address at which the block is stored when written to memory, and in the case where no error is detected for block A, the managed address would be designated and the maximum value likelihood would be written (for instance by overwriting) to that address.

This makes it possible to efficiently perform likelihood adjustments.

### Description of Fourth Embodiment

The fourth embodiment will describe a technique for improving the error correction capability for decoding devices, which are not limited to decoding devices such as turbo decoding devices that employ a scheme whereby extrinsic information is circulated.

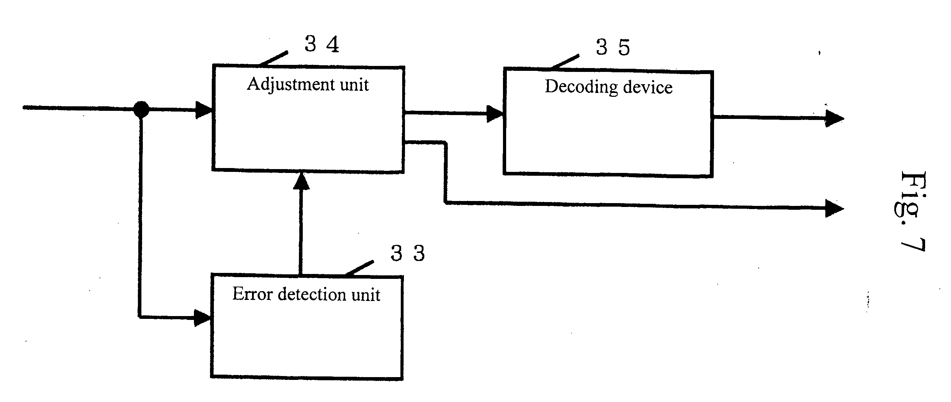

Figure 7 is a diagram illustrating an example of a decoding device (error correction decoding device) according to an embodiment of the present invention.

The data decoded by this decoding device is data that contains data obtained by error correction coding of a first data block and second data block that have been respectively subjected to error detection coding, at least.

In Figure 7, 33 represents an error detection unit, 34 represents an adjustment unit and 35 represents a decoding device.

Data coded as described above is input into this decoding device, and first of all, error detection processing is executed in the error detection unit 33. For example, error detection using CRC check bits is carried out on each data block.

Here, if both the first data block and the second data block are detected to be error-free, then decoding does not need to be performed by the decoding device 35, and the adjustment unit 34 can be controlled to output the data directly, as illustrated.

On the other hand, if all the data blocks are not error-free but there are some data blocks that are error-free (assumed to be the first data block here), then the adjustment unit 34 is notified of the error-free data block and instructed to adjust the likelihood for the first data block to one of higher reliability.

The adjustment unit 34, for example, adjusts the likelihood for the notified data block to one of a higher reliability. For example, the likelihood may be set to a maximum value.

In the case of a data block for which no error was detected by the error detection unit 33, the possibility that the data is correct is rather high, so adjusting the likelihood prevents inappropriate error correction from being carried out by the decoding device. Furthermore, having a high likelihood for data suspected to be correct accelerates the error correction for the other data blocks.

This makes it possible to improve the error correction capability for decoding devices, which are not limited to decoding devices such as turbo decoding devices that employ a scheme whereby extrinsic information is circulated.

While there are no limitations as to the coding scheme, it is preferable to employ one of the coding schemes illustrated in Figure 1, Figure 3, or Figure 5 (especially the coding scheme illustrated in Figure 5).

Furthermore, one may additionally input the decoding results of the decoding device 35 into the error detection unit 33, perform the same sort of error detection processing on each block, and again adjust the likelihood for error-free blocks in the adjustment unit 34.

This is because doing so allows for effective use of data for which the correct bits were obtained through error correction by the decoding device 35.

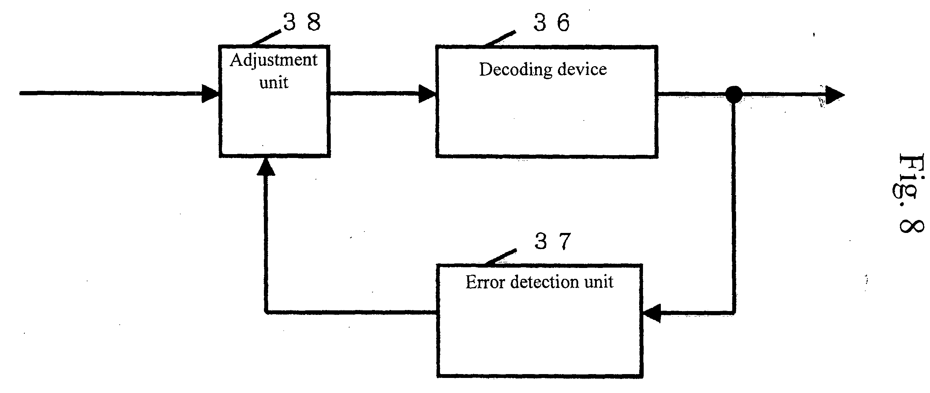

Figure 8 is a diagram illustrating an example of a decoding device (error correction decoding device) according to an embodiment of the present invention.

The data decoded by this decoding device is data that contains data obtained by error correction coding of a first data block and second data block that have been respectively subjected to error detection coding, at least.

In Figure 8, 36 represents a decoding device, 37 represents an error detection unit, and 38 represents an adjustment unit.

Data coded as described above is input into this decoding device. At the first stage of input, the adjustment unit 38 is put into pass-through mode and data to be error-corrected (decoded) is input into the decoding device 36.

The result of error correction decoding in the decoding device 36 is then input into the error detection unit 37, and error detection processing is performed on each block. For example, error detection using CRC check bits may be performed on each block.

Here, if both the first data block and the second data block are detected to be error-free, the result of the decoding can be output externally as is.

On the other hand, if all the data blocks are not error-free but there are some data blocks that are error-free (assumed to be the first data block here), then the adjustment unit 38 is notified of the error-free data block and instructed to adjust the likelihood for the first data block to one of higher reliability.

The adjustment unit 38, for example, adjusts the likelihood for the notified data block to one of a higher reliability. For example, the likelihood may be set to a maximum value.

In the case of a data block for which no error was detected by the error detection unit 37, the possibility that the data is correct is rather high, so adjusting the likelihood prevents inappropriate error correction from being carried out by the decoding device. Furthermore, having a high likelihood for data suspected to be correct accelerates the error correction of the other data blocks.

In this way, by directly adjusting the likelihood of data to be decoded rather than performing adjustments on internal data of the decoding device 26 (e.g., the extrinsic information that is circulated), the error correction capability can be improved without making the circulation of extrinsic information an essential requirement as in the case of turbo decoding devices.

While there are no limitations as to the coding scheme, it is preferable to employ one of the coding schemes illustrated in Figure 1, Figure 3, or Figure 5 (especially the coding scheme illustrated in Figure 5).

Although specific embodiments of the present invention have been described, it will be understood by those of skill in the art that there are other embodiments that are equivalent to the described embodiments. Accordingly, it is to be understood that the invention is not to be limited by the specific illustrated embodiments, but only by the scope of the appended claims.

## Claims

1. A turbo decoding device for decoding data that is obtained by performing error detection coding on a plurality of data blocks and further subjecting that data to turbo coding that includes interleaving in the coding process, comprising:
a rearrangement unit operable to perform interleaving between a first decoding a second decoding;
an error detection unit operable to perform error detection processing for each block based on data after the first decoding; and
an adjustment unit operable to adjust a likelihood indicated by data obtained after decoding in the first decoder but prior to the interleaving and corresponding to blocks evaluated as having no errors by the error detection unit, so as to increase reliability of the data.

2. A turbo decoding device for decoding data that is obtained by performing error detection coding on a plurality of data blocks and further subjecting that data to turbo coding that includes interleaving in the coding process, comprising:
a rearrangement unit operable to perform deinterleaving between a first decoding a second decoding;
an error detection unit operable to perform error detection processing for each the block based on data after the second decoding; and
an adjustment unit operable to adjust likelihoods indicated by data obtained after decoding in the second decoder and after the deinterleaving and corresponding to blocks evaluated as having no errors by the error detection unit, so as to increase the reliability of the data.

3. A turbo decoding device for decoding data that is obtained by performing error detection coding on a plurality of data blocks and further subjecting that data to turbo coding that includes interleaving in the coding process, comprising:
an error detection unit operable to perform error detection processing on each data block in a non-interleaved region of the data; and
an adjustment unit operable to adjust likelihoods corresponding to data blocks for which no error was detected by the error detection unit, in the non-interleaved region of the data, so as to increase the reliability of the data.

4. A coding device comprising:
a rearrangement unit operable to rearrange data obtained by performing error detection coding on a plurality of data blocks so as to mix that data between blocks; and
a turbo coding unit operable to perform error correction coding on the rearranged data.

5. A turbo decoding device for performing decoding on data obtained by rearranging data obtained by performing error detection coding on a plurality of data blocks so as to mix that data between blocks in a rearrangement unit, and further subjecting the rearranged data to turbo coding that includes interleaving in the coding process, comprising:
an error detection unit operable to perform error detection on each data block in a non-interleaved region; and
an adjustment unit operable to adjust likelihoods corresponding to data blocks for which no error was detected by the error detection unit, in a non-interleaved region, so as to increase reliability of the data.

6. A decoding device as set forth in any of the claims 1, 2, 3 or 5, wherein the adjustment unit is further operable to adjust the likelihoods by increasing the likelihoods for data blocks for which no error was detected;
wherein the likelihood after being increased is a value greater than a value that can be taken on by the likelihood of data to be decoded that is input into the decoding device.

7. A turbo decoding device for performing decoding on data that is obtained by performing error detection coding on a plurality of data blocks and further subjecting that data to turbo coding that includes interleaving in the coding process, comprising:
a memory operable to perform interleaving or deinterleaving in the decoding process; and
a rewriting unit operable to rewrite likelihoods stored in the memory for data blocks that were evaluated as having no errors in the decoding process through error detection processing.

8. A turbo decoding device as set forth in Claim 7, wherein the rewriting unit is further operable to perform the rewriting based on management information in a management unit that manages addresses of the likelihoods to be rewritten for each block.

9. A decoding device as set forth in Claim 7, wherein the rewriting unit is further operable to rewrite likelihoods stored in the memory by increasing the likelihoods for data blocks for which no error was detected;
wherein the likelihood after being increased is a value greater than a value that can be taken on by the likelihood of data to be decoded that is input into the decoding device.

10. A decoding device for performing error correction decoding on data that is obtained by performing error detection coding on a plurality of data blocks and further subjecting that data to error correction coding, comprising:
an error detection unit operable to perform error detection on the data to be decoded prior to the decoding;
an adjustment unit operable to perform adjustment so as to increase reliability of likelihoods for the data blocks for which no error was detected by the error detection unit; and
a decoding unit operable to perform error correction decoding using the likelihoods after the adjustment.

11. A decoding device as set forth in Claim 10, wherein the error detection unit is further operable to perform error detection on the result of the decoding and the adjustment unit is further operable to perform adjustment so as to increase reliability of likelihoods for the data blocks for which no error was detected in the additional error detection processing by the error detection unit.

12. A decoding device as set forth in Claim 10, wherein the adjustment unit is further operable to perform adjustment by increasing the likelihoods for data blocks for which no error was detected;
wherein the likelihood after being increased by the adjustment is a value greater than a value that can be taken on by the likelihood of data to be decoded that is input into the decoding device.

13. A decoding device for performing error correction decoding on data that is obtained by performing error detection coding on a plurality of data blocks and further subjecting that data to error correction coding, comprising:
a decoding unit operable to perform decoding on data to be decoded;
an error detection unit operable to perform error detection for each data block based on results of the decoding; and
an adjustment unit operable to adjust likelihoods for those data blocks to be decoded that had no error according to the error detection so as to increase reliability of the data;
wherein the data to be decoded is again input into the decoding unit to execute decoding after the adjustment.

14. The decoding device of claim 13, wherein the adjustment unit is further operable to adjust the likelihoods by increasing the likelihoods for data blocks for which no error was detected in an iterative decoding process;
wherein the likelihood after being increased by the adjustment is a value greater than a value that can be taken on by the likelihood of data to be decoded that is input into the decoding device.

15. A turbo decoding device for performing decoding on data that is obtained by performing error detection coding on a plurality of data blocks and further subjecting that data to turbo coding that includes interleaving in the coding process, comprising:
an adjustment unit operable to increase likelihoods for data blocks for which no error was detected in an iterative decoding process;
wherein the likelihood after being increased by the adjustment is a value greater than a value that can be taken on by the likelihood of data to be decoded that is input into the decoding device.
